# EUROPEAN PATENT APPLICATION

(11) **EP 1 624 480 A1**
(43) Date of publication of application: **08.02.2006**
(21) Application number: 04732774.7
(22) Date of filing: 13.05.2004
(51) Int. Cl.: H01L 21/027, G03F 1/16, G03F 7/20, H01J 37/305

(54) **EXPOSURE METHOD, MASK, SEMICONDUCTOR DEVICE MANUFACTURING METHOD, AND SEMICONDUCTOR DEVICE**

(30) Priority: 15.05.2003 JP 2003137802
(71) Applicant: SONY CORPORATION, Tokyo 141-0001 (JP)
(72) Inventor: YOSHIZAWA, Masaki Sony Corporation, Shinagawa-ku, Tokyo 1410001 (JP)
(74) Representative: Müller, Frithjof E.
(86) International application number: PCT/JP2004/006763
(87) International publication number: WO 2004/102645

(57) **Abstract**

To provide an exposure method and mask capable of suppressing a fluctuation of a dimension of a resist pattern caused by a flexure of a membrane and a semiconductor device formed with a fine pattern in high accuracy and a method of producing the same. The exposure method placing an object to be exposed at a surface side of the mask and irradiating the exposure beam to the object to be exposed via the mask from another side of the mask has the steps of: obtaining a distribution of an amount of a flexure of the held mask, and irradiating the exposure beam at an exposure, a focal length, or a dimension of the mask pattern which is changed depending on the amount of the flexure to correct the fluctuation of the dimension depending on the amount of the flexure of a pattern being projected to the object to be exposed. The mask used for the same, the method of producing the semiconductor device including the same, and the semiconductor device produced by the same, are also provided.

## Description

### TECHNICAL FIELD

The present invention relates to an exposure method using a mask, a mask, a method of producing a semiconductor device, and a semiconductor device.

### BACKGROUND ART

As a next generation exposure method instead of photolithography, projection type lithography using charged particles such as an electron beam and an ion beam, soft X-ray (EUV: an extreme ultraviolet), X-ray, or other exposure beams has been developed. In the projection type lithography, a mask having a thin film membrane of approximately 100 nm to 10 µm in a thickness is used and a pattern formed in the membrane is projected to a resist on a wafer.

A mask in which the aperture is formed with a predetermined pattern in the membrane is called a stencil mask. The stencil mask has been disclosed in, for example, H. C. Pfeiffer, *Jpn. J*. *Appl. Phys.* 34, 6658 (1995). Also, a mask in which a metal film for scattering the exposure beam is formed with a predetermined pattern on the membrane in which the exposure beam passes through is called a membrane mask. The membrane mask has been disclosed in, for example, L. R. Harriott, *Journal of* Vacuum Science and *Technology B 15,* 2130 (1997).

The projection type lithography using the electron beam has a method of reducing and projecting the electron beam passing through the mask (for example, PREVAIL; projection exposure with variable axis immersion lenses) and a method of making the mask proximity to the wafer and projecting a mask pattern at an equal scale (LEEPL; low energy electron-beam projection lithography). The document disclosing the above stencil mask also has disclosed PREVAIL. LEEPL has also been disclosed in, for example, T. Utsumi, Journal *of* Vacuum *Science* and *Technology B17,* 2840 (1999). In LEEPL, a low energy electron beam is used and the electron beam does not pass through the membrane mask. Therefore, LEEPL is used with the stencil mask, not the membrane mask. For example, Japanese Unexamined Patent Application No. 2002-231599, Japanese Unexamined Patent Application No. 2002-252157, Japanese Unexamined Patent Application No. 2002-270496, and Japanese Unexamined Patent Application No. 2002-343710 have disclosed the stencil mask preferably to LEEPL.

In the stencil mask and the membrane mask, due to internal stress of the membrane and the gravity added to the mask in an exposure state, a flexure occurs in a pattern projecting region. Blow, the pattern projecting region is defined as a region able to form a transparent portion of the exposure beam. A thick film of a silicon wafer etc. for supporting the membrane is stacked on the membrane except the pattern projecting region.

The stencil mask formed with a beam(struts)-shaped reinforcing portion (beam) 102 in the membrane 101 shown in FIG. 1 has been also disclosed in the Japanese Unexamined Patent Application No. 2002-231599 which is one of the above documents. However, depending on a width or an interval of the beams, the beam (the struts) may also flex together with the membrane. In this way, the mask in which the membrane and the beam (the struts) flex includes a beam portion (a struts portion) where the aperture portion (the transparent portion of the exposure beam) is not actually arranged as the pattern projecting portion.

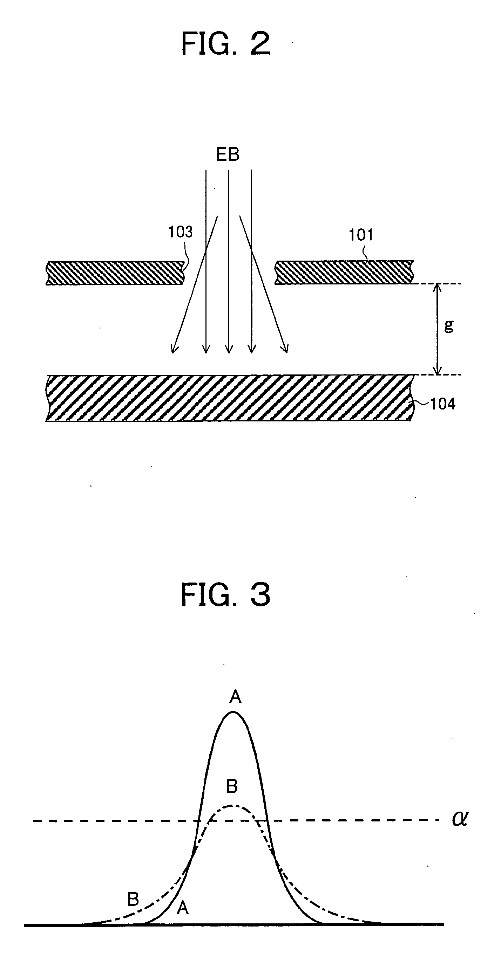

The flexure of the membrane causes the interval between the wafer and the mask to have a different distribution depending on an amount of the flexure of the membrane. Below, the interval between the wafer and the mask is defined as a gap. As shown in FIG. 2, an electron beam EB passing through the aperture 103 of the membrane 101 contains a vertical component and additionally a tilt component. Therefore, the larger the gap g between the membrane 101 and the wafer 104 is, the larger area the electron beam EB is irradiated in the resist.

FIG. 3 is a view of an example of an integrated exposure intensity. In FIG. 3, a curved line A indicates an example in the case where the gap g in FIG. 2 is small, and a curved line B indicates an example in the case where the gap g is large. As shown in FIG. 3, when energy of the electron beam is fixed and the gap becomes large, the integrated exposure intensity becomes small as shown in the curved line B and a width of an irradiating region is made large. Also, a state shown in the curved line B corresponds to a state where a focus is blurred more than that of the curved line A.

Energy stored in a certain part of a resist by the exposure exceeds a predetermined value (referred to a threshold α), as a result, the resist changes its solubility against a development solution (latent image). By a development, a resist pattern is formed with a latent image pattern. Due to a request for miniaturizing a pattern, the threshold α is determined highly within a range lower than a peak height of the integrated exposure intensity. Therefore, as shown in FIG. 3, in a portion large in the gap (the curved line B), a dimension of the resist pattern relatively is made small.

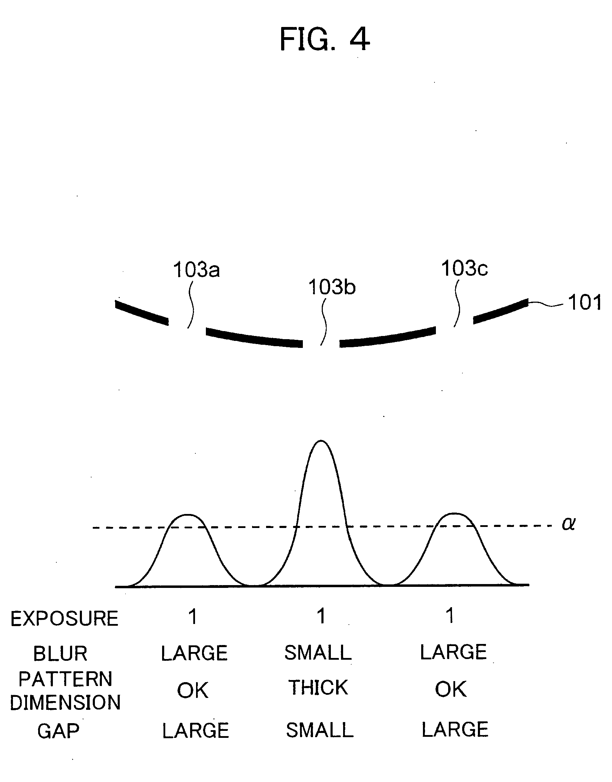

FIG. 4 is a schematic view showing a fluctuation of the dimension of the resist pattern in exposing the resist on the wafer via the flexing mask by a conventional exposure method. It is shown that an integrated exposure intensity in the respective apertures, a blur of the pattern and the dimension of the pattern formed in the resist, and the gap between the membrane 101 and the wafer in irradiating the same exposure to the apertures 103a to 103c respectively. It is assumed that line widths of the apertures 103a to 103c formed in the membrane 101 shown in FIG. 4 are equal. Due to the flexure of the membrane 101, the gap is made the minimum at the aperture 103b.

When irradiating the electron beam to the apertures 103a to 103b at the same exposure, the electron beam passed through the aperture 103b supplies the integrated exposure intensity corresponding to the curved line A in FIG. 3 and the electron beam passed through the apertures 103a and 103c supplies the same corresponding to the curved line B in FIG. 3. The exposure irradiated to the apertures 103a to 103b is assumed to be 1. When the resist pattern having a desired dimension is formed by irradiating the electron beam passed through the apertures 103a and 103c, the dimension of the resist pattern projected by irradiating the electron beam passed through the aperture 103b is made large.

The exposure by using the flexing mask described above causes the dimension of the formed resist pattern to fluctuate and an exposure margin to drop. A production of a semiconductor device by an etching step etc. using such resist pattern causes a device performance or a yield to drop.

### DISCLOSURE OF THE INVENTION

The present invention was made in consideration of the above disadvantage, therefore, the present invention is to provide an exposure method capable of suppressing a fluctuation of a dimension of a resist pattern caused by a flexure of a membrane, and a mask.

Further, the present invention is to provide a method of producing a semiconductor device capable of forming a fine pattern in high accuracy and a semiconductor device formed with the fine pattern in high accuracy.

To achieve the above object, according to the present invention, there is provided an exposure method holding a mask in which a transparent portion for an exposure beam is formed with a predetermined mask pattern, placing an object to be exposed at a surface side of the mask, and irradiating the exposure beam to the object to be exposed via the mask from another side of the mask, the method having the steps of: obtaining a distribution of an amount of a flexure of the held mask, and irradiating the exposure beam at an exposure or a focal length which is changed depending on the amount of the flexure to correct a fluctuation of the dimension depending on the amount of the flexure of a pattern being projected to the object to be exposed.

To achieve the above object, according to the present invention, there is provided an exposure method holding a mask in which a transparent portion for an exposure beam is formed with a predetermined mask pattern, placing an object to be exposed at a surface side of the mask, and irradiating the exposure beam to the object to be exposed via the mask from another side of the mask, the method having the steps of: obtaining an amount of a distribution of a flexure of a held first mask; producing a second mask at a dimension of the mask pattern which is changed depending on the amount of the flexure to correct a fluctuation of the dimension depending on the amount of the flexure of a pattern being projected to the object to be exposed; and irradiating the exposure beam to the object to be exposed via the second mask.

Therefore, the fluctuation of the dimension of the pattern caused by the flexure of the mask is suppressed. By changing the exposure or the focal length of the exposure beam, or the dimension of the mask pattern in the mask, the fluctuation of the dimension of the projected mask pattern, which depends on a distance between the mask and the object to be exposed, is corrected.

To achieve the above object, according to the present invention, there is provided a mask formed with a transparent portion of a predetermined mask pattern for an exposure beam, wherein a dimension of the mask pattern is corrected depending on an amount of a flexure of the mask when the mask is held, an object to be exposed is placed at a surface side of the mask and the exposure beam is irradiated to the object to be exposed via the mask from another side of the mask. Therefore, in the pattern projected to the object to be exposed, the fluctuation of the dimension caused by the flexure of the mask is suppressed.

To achieve the above object, according to the present invention, there is provided a method of producing a semiconductor device including an exposure method corresponding to the exposure method according to the present invention. Therefore, the resist pattern having a desired dimension can be formed and a fine pattern can be formed in a semiconductor device in high accuracy.

Further, according to the present invention, there is provided a semiconductor device having a pattern at least locally formed by using a resist pattern in which a fluctuation of a dimension caused by a flexure of a mask is corrected by changing an exposure or a focus distance of an exposure beam, or a mask pattern dimension depending on an amount of the flexure of the mask. Therefore, a fine pattern is formed in high accuracy and a reduction of a device performance and a reduction of a yield caused by the fluctuation of the resist pattern are prevented.

### BRIEF DESCRIPTION OF THE DRAWINGS

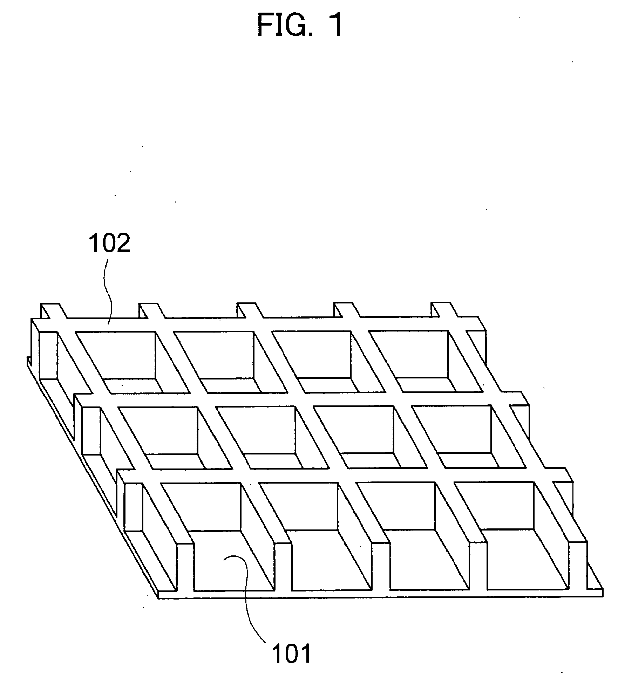

FIG. 1 is a perspective view explaining an example of a stencil mask.
FIG. 2 is a view showing a spread of an electron beam depending on an interval (a gap) between a wafer and a mask.
FIG. 3 is a view showing an example of an integrated exposure intensity.
FIG. 4 is a view showing a dimension of a resist pattern given by a conventional exposure method.
FIG. 5 is a flow chart showing an exposure method according to a first embodiment of the present invention.
FIG. 6 is a view showing a relationship between an interval (the gap) of a wafer and a mask and a dimension of a resist pattern according to the first embodiment of the present invention.
FIG. 7 is a view showing a relationship between an exposure and the dimension of the resist pattern according to the first embodiment of the present invention.
FIG. 8 is a view showing the dimension of the resist pattern given by an exposure method according to the first embodiment of the present invention.
FIG.9 is a flow chart showing an exposure method according to a second embodiment of the present invention.
FIG. 10 is a view showing a dimension of a resist pattern given by the exposure method according to the second embodiment of the present invention.
FIG. 11 is a flow chart showing an exposure method according to a third embodiment of the present invention.
FIG. 12 is a view showing a dimension of a resist pattern given by the exposure method according to the third embodiment of the present invention.

### BEST MODE FOR CARRYING OUT THE INVENTION

Hereinafter, embodiments of an exposure method, a mask, a method of producing a semiconductor device, and a semiconductor device according to the present invention will be described with reference to the drawings. The below embodiments is preferably applied to LEEPL.

### (First embodiment)

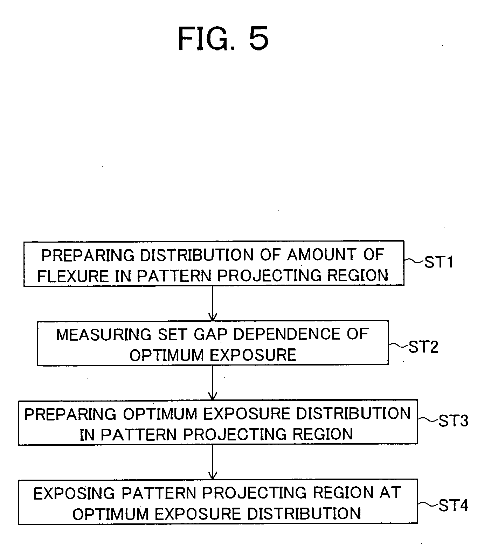

In the present embodiment, an exposure is adjusted depending on an amount of a flexure of a mask to suppress a fluctuation of a dimension of a resist pattern. With reference to a flow chart in FIG. 5, an exposure method of the present embodiment will be described.

### Step 1 (ST1)

First, the amount of the flexure of a stencil mask or a membrane mask is measured by an electrostatic capacitance sensor etc. to obtain a distribution g (x, y) of the amount of the flexure in a pattern projecting region. Otherwise, with considering influences of internal stress and gravity of a membrane, the distribution g (x, y) of the amount of the flexure may be calculated. Here, the minimum value of the interval (a gap) between a wafer and the mask is defined as "gₘᵢₙ", the maximum value thereof is defined as "gₘₐₓ".

For an explanation mentioned later, a set gap of Z µm is defined as a state to be gₘᵢₙ = Z µm. For example, when the set gap is 40 µm, it assumed that the flexure being gₘᵢₙ of 40 µm at a position (x₁, y₁) and gₘₐₓ of 50 µm at a position (x₂, y₂) in a pattern projecting region occurs in the mask.

### Step 2 (ST2)

A relationship between an optimum exposure and the set gap is measured by an exposure experiment. The optimum exposure is defined as an exposure for forming a resist pattern to be paid attention at the same dimension as a designed value (CD: critical dimension). By the exposure experiment, the relationship between the set gap and the exposure is obtained in the designed CD in advance.

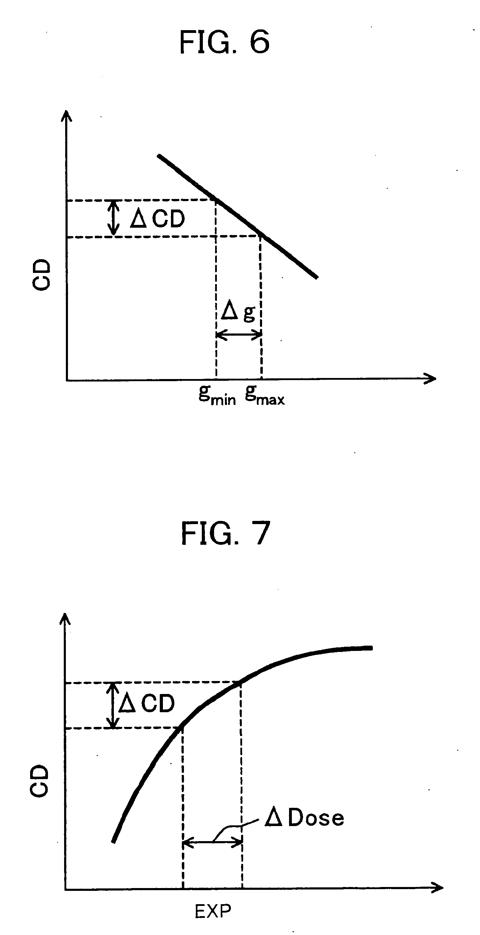

As shown in FIG. 6, when the set gap is made large in fixing the exposure, so the CD is made small. And as shown in FIG. 7, and the exposure is made large in fixing the set gap, so the CD is made large. In the pattern projecting region, by relating the set gap to the exposure respectively obtained the same CD, the set gap dependence of the optimum exposure can be obtained.

For example, a desired dimension of the resist pattern is assumed as 100 nm and the exposure experiment is performed. As a result, the optimum exposure is 2.0 µC/cm² when the set gap is set to 40 µm and the optimum exposure is 2.2 µC/cm² when the set gap is set to 50 µm. Note that, step 1 and step 2 may be reversed in those order.

### Step 3 (ST3)

By using the distribution g(x, y) of the amount of the flexure prepared in step 1 and the optimum exposure dependence on the set gap prepared in step 2, an optimum exposure distribution Dose(x, y) in the pattern projecting region for correcting a fluctuation of the dimension caused by the flexure is obtained. In the above example, Dose (x₁, y₁) of 2.0 µC/cm² and Dose (x₂, y₂) of 2.2 µC/cm² are respectively obtained. Note that, ACD in Ag = gₘₐₓ - gₘᵢₙ shown in FIG. 6 corresponds to an intra-surface fluctuation of CD caused by the flexure. In relating ACD shown in FIG. 6 to the exposure EXP in FIG. 7, it is learned a range ΔDose of adjusting the optimum exposure in order to overcome the intra-surface fluctuation of CD caused by the flexure.

### Step 4 (ST4)

Based on the optimum exposure distribution Dose(x, y) prepared in step 3, the exposure is adjusted and the resist is exposed on the wafer. As a result, the uniformity dimension of the resist pattern is achieved in the pattern projecting region even if using the flexing mask.

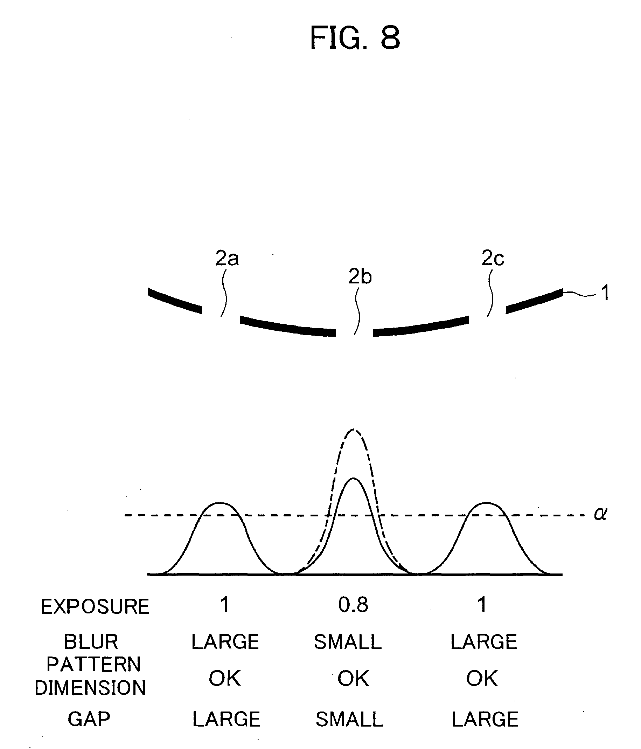

FIG. 8 is a view showing a dimension of the resist pattern in exposing the resist on the wafer via the flexing mask by the exposure method of the present embodiment. It shows a blur of the pattern and a pattern dimension formed in the resist in irradiating the adjusted exposure to the apertures 2a to 2c, and the gap between the membrane 1 and the wafer. A curved solid line indicates the integrated exposure intensity. The resist pattern is formed in a portion in which energy stored in the resist by the exposure excesses the threshold α. The line widths of the apertures 2a to 2c formed in the membrane 1 in FIG. 8 are the same in a state in which the membrane 1 does not flex.

Due to the flexure of the membrane 1, the gap becomes the minimum at the aperture 2b. According to the exposure method of the present embodiment, the exposure is adjusted depending on the gap. When the exposure of the apertures 2a and 2c having a relatively large gap is defined to 1, the exposure of the aperture 2b having a relatively small gap is set to, for example, 0.8.

As a reference to the above, the integrated exposure intensity in the case of setting the exposure of the aperture 2b at 1 is shown as a curved broken line. The curved broken line indicates the same as the integrated exposure intensity of the aperture 103b shown in FIG. 4. By making the exposure for the aperture 2b small, a peak of the integrated exposure intensity becomes small. Since the gap at the aperture 2b is small, a spread of the integrated exposure intensity of the width direction which is caused by a tilt component of the electron beam is small. As shown in FIG. 8, the dimension of the resist pattern formed via the aperture 2b is made thinner than that formed via the aperture 103b in FIG. 4, consequently, the dimension of the resist pattern projected at the apertures 2a to 2c having different gaps can be achieved uniformity.

### (Second embodiment)

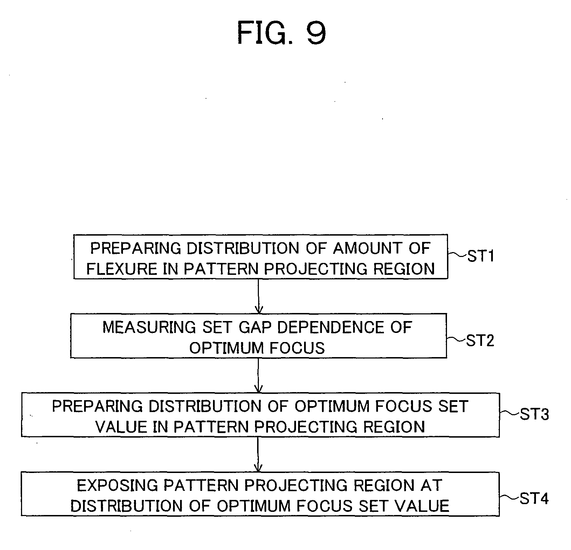

In the present embodiment, a focus (focal length) is adjusted depending on the amount of the flexure of the mask to suppress the fluctuation of the dimension of the resist pattern. With reference to a flow chart of FIG. 9, an exposure method of the present embodiment will be described.

### Step 1 (ST1)

First, in the same way of Step 1 of the first embodiment, a distribution g(x, y) of the amount of the flexure is obtained in the pattern projecting region of the stencil mask or the membrane mask. For example, it is assumed that the flexure being gₘᵢₙ of 40 µm at a position (x₁, y₁) and gₘₐₓ of 50 µm at a position (x₂, y₂) in the pattern projecting region occurs in the mask.

### Step 2 (ST2)

A relationship between the optimum focus and the set gap is measured by the exposure experiment. Here, the optimum focus is defined as a focus for forming the resist pattern, which is formed and exposed by the optimum exposure, at the same dimension (CD) as the designed value. Also, as the exposure beam, the electron beam is used, and a voltage (V) applied to a condenser lens of an electric system is defined as a focus set value. By changing the focus set value, the focal length of the exposure beam is adjusted.

The exposure experiment is performed in the same way of Step 2 in the first embodiment to obtain the relationship between the optimum exposure and the set gap. Namely, the optimum exposure for obtaining a desired CD is prepared in the predetermined set gap. Then, the set gap and the optimum exposure are made fixed within a range that the desired CD is obtained and the focus set value is changed, and then the fluctuation of CD is measured. As a result, in the predetermined set gap and exposure, the focus set value dependence of CD is obtained.

Such focus set value dependence of CD is measured by using the set gap and the optimum exposure which differ from the above. The set gap dependence of CD shown in FIG. 6 can be known in a step of measuring the relationship between the optimum exposure and the set gap. By relating the set gap to the focus set value obtained the same CD, the relationship between the optimum focus set value and the set gap can be obtained in a certain exposure. Namely, the focus is determined by the focus set, the relationship between the optimum focus set value and the set gap can be obtained in a certain exposure.

For example, it is assumed that a desired CD is 100 nm, the optimum exposure causing CD to be 100 nm is 2.2 µC/cm² when the set gap is 40 µm, and the focus set value (the optimum focus set value) is set to 1400 in this time. When the exposure is fixed as 2.2 µC/cm² and the set gap is set to 50 µm, the optimum focus set value for obtaining 100 nm in CD becomes 1500.

### Step 3 (ST3)

By using the distribution g(x, y) of the amount of the flexure prepared in Step 1 and the optimum focus set value depending on the set gap prepared in Step 2, the optimum focus set distribution Focus(x, y) for correcting the dimension fluctuation due to the flexure is obtained in the pattern projecting region. In the above example, Focus (x₁, y₁) of 1400 and Focus (x₂, y₂) of 1500 are obtained.

### Step 4 (ST4)

Based on the optimum focus set value distribution Focus(x, y) prepared in Step 3, the focus position is adjusted and then the resist is exposed on the wafer. As a result, uniformity resist pattern dimension is achieved in the pattern projecting region even if using the flexing mask.

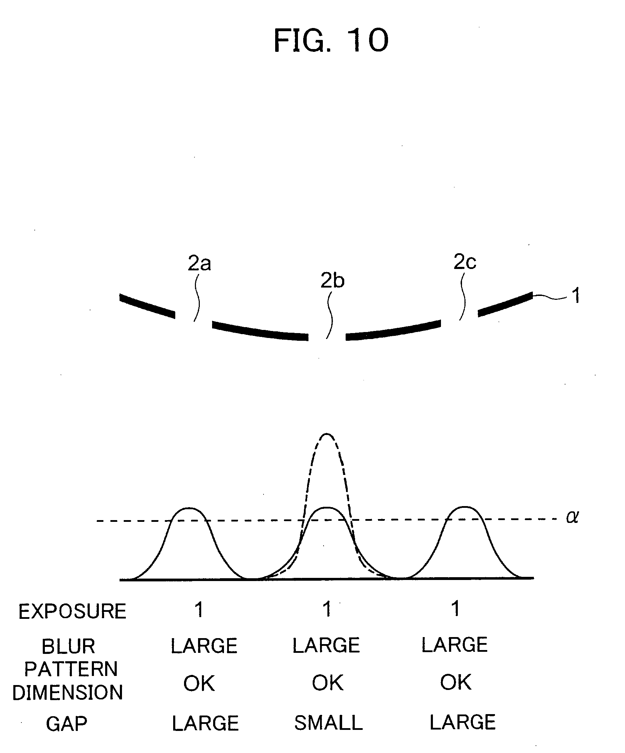

FIG. 10 is a view showing a resist pattern dimension in exposing the resist on the wafer via the flexing mask by the exposure method of the present embodiment. It shows a blur of the pattern and a pattern dimension formed in the resist in irradiating the same exposure to the apertures 2a to 2c, and the gap between the membrane 1 and the wafer. A curved solid line indicates the integrated exposure intensity. The resist pattern is formed at a portion where energy stored in the resist by the exposure exceeds the threshold a. The line widths of the apertures 2a to 2c formed in the membrane 1 shown in FIG. 10 are equal in a state where the membrane 1 is not flexed.

Due to the flexure of the membrane 1, the gap becomes the minimum at the aperture 2b. According to the exposure method of the present embodiment, the exposure is fixed at the every apertures 2a to 2c and the focus is adjusted depending on the resist pattern. The focus of the electron beam irradiated in the resist is shifted to a position in front of the resist (a side near the mask) or a deeper position in the resist (a side near the wafer of the underlying resist) to blur the beam spot on the resist.

As a reference to the above, the integrated exposure intensity in the case of setting the focus set value of the aperture 2b at the same value as the focus set value of the apertures 2a and 2c is shown by a curved broken line. The curved broken line indicates the same as the integrated exposure intensity of the aperture 103b shown in FIG. 4. By blurring the focus of the aperture 2b, the peak of the integrated exposure intensity becomes small and the dimension of the resist pattern projected via the aperture 2b is made large. As shown in FIG. 10, the dimension of the resist pattern projected via the aperture 2b is made narrow in comparison with the dimension of the resist pattern projected via the aperture 103b of FIG. 4. As a result, the dimension of the resist pattern projected via the apertures 2a to 2c having different gaps can be achieved uniformity.

### (Third embodiment)

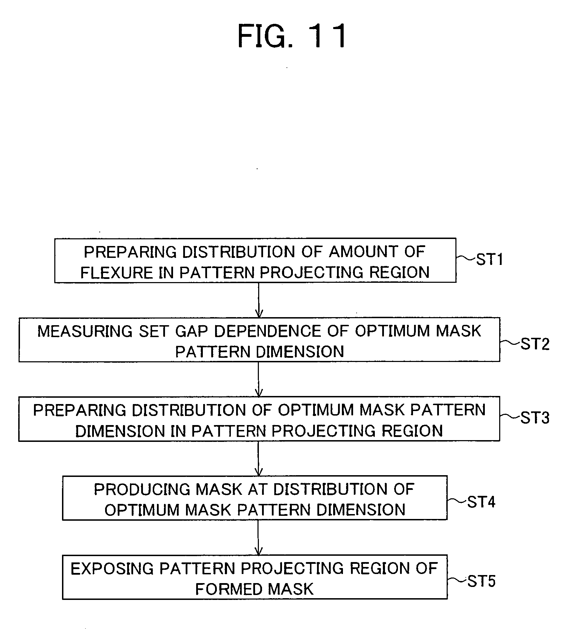

In the present embodiment, the dimension of the mask pattern is adjusted depending on the flexure of the mask to suppress the fluctuation of the dimension of the resist pattern. With reference to a flow chart of FIG. 11, an exposure method of the present embodiment will be described.

### Step 1 (ST1)

First, in the same way as Step 1 in the first embodiment, a distribution g(x, y) of the amount of the flexure is obtained in the pattern projecting region of the stencil mask or the membrane mask (a first mask). For example, it is assumed that the flexure being gₘᵢₙ of 40 µm in a position (x₁, y₁) and gₘₐₓ of 50 µm in a position (x₂, y₂) in the pattern projecting region occurs in the mask.

### Step (ST2)

A relationship between the optimum mask pattern dimension and the set gap is measured by the exposure explanation. The optimum mask pattern dimension is defined as a mask pattern dimension for forming a resist pattern, which is exposed and formed by the optimum exposure, at the same dimension as the designed value (CD). First, the exposure experiment is performed in the same way as Step 2 of the first embodiment to prepare the relationship between the optimum exposure and the set gap. Namely, the optimum exposure for obtaining a desired CD is prepared in a predetermined set gap. Then, the set gap and the optimum exposure are fixed within a range where the desired CD is obtained, and the CDs are measured in the different mask patterns. As a result, a mask pattern dimension dependence of CD is obtained in the predetermined set gap and exposure.

Such mask pattern dimension dependence of CD is measured by using the set gap and the optimum exposure which differ from the above. The set gap dependence of CD as shown in FIG. 6 can be known in a step of measuring the relationship between the optimum exposure and the set gap. By relating the set gap to the mask pattern dimension in which the same CD is obtained, the relationship between the optimum mask pattern and the set gap can be obtained in a certain exposure.

For example, it is assumed that a desired CD is 100 nm, the optimum exposure causing CD to be 100 nm is 2.2 µC/cm² when the set gap is 40 µm, and the mask pattern dimension (the optimum mask pattern dimension) is set to 1400 in this time. When the exposure is fixed as 2.2 µC/cm² and the set gap is set to 40 µm, the optimum mask pattern dimension for obtaining 100 nm in CD becomes 90 nm.

### Step 3 (ST3)

By using the distribution g(x, y) of the amount of the flexure prepared in Step 1 and the optimum mask pattern dimension depending on the set gap prepared in Step 2, the optimum mask pattern dimension distribution MaskCD(x, y) for correcting the dimension fluctuation caused by the flexure is obtained in the pattern projecting region. In the above example, MaskCD (x₁, y₁) of 90 nm and MaskCD (x₂, y₂) of 100 nm are obtained.

### Step 4 (ST4)

A mask (a second mask) formed with a mask pattern at the optimum mask pattern dimension distribution MaskCD(x, y) prepared in Step 3 is formed.

### Step 5 (ST5)

By using the mask formed in Step 4, the exposure is performed at fixed exposure and focus set value. As a result, uniformity resist pattern dimension is achieved in the pattern projecting region even if using the flexing mask.

Note that, in the case of measuring a distribution of the amount of the flexure in Step 1, the measurement is performed by using the first mask and then the second mask is formed. However, in the case of preparing the distribution of the amount of the flexure by a calculation in Step 1, the first mask may not be formed. Further, the first mask is formed, and the amount of the flexure may be measured and calculated in the first mask to obtain the distribution thereof. The second mask corresponds to a mask according to the present invention.

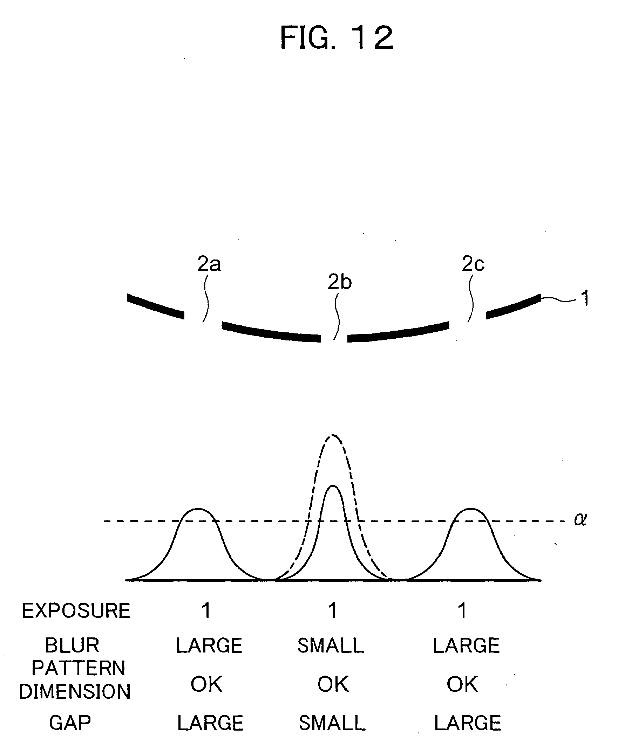

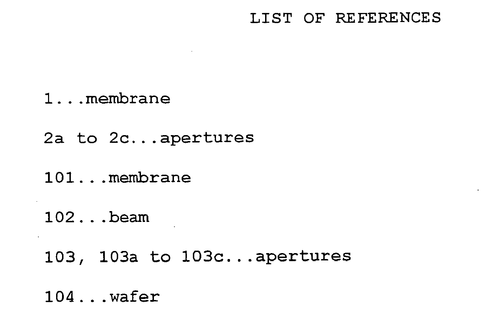

FIG. 12 is a view showing a dimension of a resist pattern in exposing the resist on the wafer via the flexing mask by the exposure method of the present embodiment. It shows an integrated exposure intensity at the respective apertures in irradiating an equal exposure to the apertures 2a to 2c, a blur of the pattern and a pattern dimension formed in the resist, and the gap between the membrane 1 and the wafer. A curved solid line indicates the integrated exposure intensity. The resist pattern is formed at a portion where energy stored in the resist by the exposure exceeds the threshold α. As shown in FIG. 12, in the apertures 2a to 2c, the flexure of the membrane 1 causes the gap at the aperture 2b to make the minimum and the line width thereof to make small.

According to the exposure method of the present embodiment, the exposure and the focus of the exposure beam are the same in the apertures 2a to 2c. As reference to the above, the integrated exposure intensity in the case of setting the mask pattern dimension of the aperture 2b at the same value as the mask pattern dimension of the apertures 2a and 2c is shown as a curved broken line. The curved broken line indicates the same as the integrated exposure intensity of the aperture 103b shown in FIG. 4.

By making the mask pattern dimension of the aperture 2b small, the peak of the integrated exposure intensity becomes small and a width of irradiated resist is made thin. As shown in FIG. 12, a line width of the aperture 2b of the mask pattern is made smaller in comparison with a line width of the aperture 103b of FIG. 4, as a result, the resist pattern dimension projected via the apertures 2a to 2c having different gap can be achieved uniformity.

According of the embodiment of the present invention, the flexure of the resist pattern dimension caused by the flexure of the membrane can be suppressed. And a method of producing a semiconductor device includes an exposure step according to the above exposure method. A resist pattern formed by lithography including the above exposure method is used in a process, for example, of etching etc., as a result, a dimension accuracy of a pattern is made high and a yield of a semiconductor device is improved.

A semiconductor device according to the present invention is produced by the method of producing the semiconductor device including the above exposure method. The semiconductor device according to the present invention is formed with a pattern by using a resist pattern in which the dimension flexure is suppressed, consequently, a dimension accuracy of the pattern is made high and a device performance is improved. Embodiments of the exposure method, the mask, the method of producing the semiconductor device, and the semiconductor device according to the present invention are limited to the above descriptions. For example, the present invention is applied to a projection type lithography other than LEEPL.

According to the exposure method and the mask in the present invention, the fluctuation of the resist pattern dimension caused by the flexure of the membrane can be suppressed.

According to the method of producing the semiconductor device and the semiconductor device in the present invention, a fine pattern is formed in high accuracy and yield of the semiconductor device is improved.

### INDUSTRIAL APPLICABILITY

The exposure method by using the mask according to the present invention is applicable to an exposure projecting a pattern formed in the mask to a resist film etc., and the mask according to the present invention is applicable to a mask in which a transparent portion for an exposure beam is formed with a predetermined pattern. Further, the method of producing the semiconductor device and the semiconductor device according to the present invention are applicable to, for example, a large scale integration (LSI), an integrated circuit (IC), or other semiconductor device in which a fine pattern is formed, and a production thereof.

## Claims

1. An exposure method holding a mask in which a transparent portion for an exposure beam is formed with a predetermined mask pattern, placing an object to be exposed at a surface side of the mask, and irradiating the exposure beam to the object to be exposed via the mask from another side of the mask, the method comprising the steps of:
obtaining a distribution of an amount of a flexure of the held mask, and
irradiating the exposure beam at an exposure which is changed depending on the amount of the flexure to correct a fluctuation of the dimension depending on the amount of the flexure of a pattern being projected to the object to be exposed.

2. An exposure method as set forth in claim 1, wherein a step of obtaining the distribution of the amount of the flexure of the mask includes a step of measuring the amount of the flexure.

3. An exposure method as set forth in claim 1, wherein a step of obtaining the distribution of the amount of the flexure of the mask includes a step of calculating the amount of the flexure based on internal stress of the mask.

4. An exposure method holding a mask in which a transparent portion for an exposure beam is formed with a predetermined mask pattern, placing an object to be exposed at a surface side of the mask, and irradiating the exposure beam to the object to be exposed via the mask from another side of the mask, the method comprising the steps of:
obtaining a distribution of an amount of a flexure of the held mask, and
irradiating the exposure beam at a focal length which is changed depending on the amount of the flexure to correct a fluctuation of the dimension depending on the amount of the flexure of a pattern being projected to the object to be exposed.

5. An exposure method as set forth in claim 4, wherein a step of obtaining the distribution of the amount of the flexure of the mask includes a step of measuring the amount of the flexure.

6. An exposure method as set forth in claim 4, wherein a step of obtaining the distribution of the amount of the flexure of the mask includes a step of calculating the amount of the flexure based on internal stress of the mask.

7. An exposure method holding a mask in which a transparent portion for an exposure beam is formed with a predetermined mask pattern, placing an object to be exposed at a surface side of the mask, and irradiating the exposure beam to the object to be exposed via the mask from another side of the mask, the method comprising the steps of:
obtaining a distribution of a amount of a flexure of a held first mask;
producing a second mask at a dimension of the mask pattern which is changed depending on the amount of the flexure to correct a fluctuation of the dimension depending on the amount of the flexure of a pattern being projected to the object to be exposed; and
irradiating the exposure beam to the object to be exposed via the second mask.

8. An exposure method as set forth in claim 7, wherein a step of obtaining the distribution of the amount of the flexure of the first mask includes a step of measuring the amount of the flexure.

9. An exposure method as set forth in claim 7, wherein a step of obtaining the distribution of the amount of the flexure of the first mask includes a step of calculating the amount of the flexure based on an internal stress of the mask.

10. A mask formed with a transparent portion of a predetermined mask pattern for an exposure beam, wherein a dimension of the mask pattern is corrected depending on an amount of a flexure of the mask when the mask is held, an object to be exposed is placed at a surface side of the mask and the exposure beam is irradiated to the object to be exposed via the mask from another side of the mask.

11. A method of producing a semiconductor device including an exposure step of holding a mask formed with a transparent portion of a predetermined mask pattern for an exposure beam, placing a wafer at a surface side of the mask, and irradiating the exposure beam to a resist formed on the wafer via the mask from another side of the mask, the exposure step comprising the steps of:
obtaining a distribution of an amount of a flexure of the held mask, and
irradiating the exposure beam at an exposure which is changed depending on the amount of the flexure to correct a fluctuation of the dimension depending on the amount of the flexure of a pattern being projected to the resist.

12. A method of producing a semiconductor device including an exposure step of holding a mask formed with a transparent portion of a predetermined mask pattern for an exposure beam, placing a wafer at a surface side of the mask, and irradiating the exposure beam to a resist on the wafer via the mask from another side of the mask, the exposure step comprising the steps of:
obtaining a distribution of an amount of a flexure of the held mask, and
irradiating the exposure beam at the focus distance which is changed depending on an amount of the flexure to correct a fluctuation of the dimension depending on an amount of the flexure of a pattern being projected to the resist.

13. A method of producing a semiconductor device including an exposure step of holding a mask formed with a transparent portion of a predetermined mask pattern for an exposure beam, placing a wafer at a surface side of the mask, and irradiating the exposure beam to a resist on the wafer via the mask from another side of the mask, the exposure step comprising the steps of:
obtaining a distribution of an amount of a flexure of a held first mask;
producing a second mask at the dimension of the mask pattern which is changed depending on the amount of the flexure to correct a fluctuation of the dimension depending on the amount of the flexure of a pattern being projected to the resist; and
irradiating the exposure beam to the resist.

14. A semiconductor device comprising a pattern at least locally formed by using a resist pattern in which a fluctuation of a dimension caused by a flexure of a mask is corrected by changing an exposure depending on an amount of the flexure of the mask.

15. A semiconductor device comprising a pattern at least locally formed by using a resist pattern in which a fluctuation of a dimension caused by a flexure of a mask is corrected by changing a focal length of an exposure beam depending on the amount of the flexure of the mask.

16. A semiconductor device comprising a pattern at least locally formed by using a resist pattern in which a fluctuation of a dimension caused by a flexure of a mask is corrected by changing a dimension of a mask pattern of an exposure beam depending on an amount of the flexure of the mask.
